# EUROPÄISCHE PATENTSCHRIFT

(11) **EP 0 938 744 B1**
(45) Veröffentlichungstag und Bekanntmachung des Hinweises auf die Patenterteilung: **13.03.2002**
(21) Anmeldenummer: 97910229.0
(22) Anmeldetag: 29.09.1997
(51) Int. Cl.: H01L 21/00

(54) **VERFAHREN ZUR WAFERIDENTIFIZIERUNG IN DER CHIPFERTIGUNG UND VORRICHTUNG ZUR DURCHFÜHRUNG DES VERFAHRENS**
METHOD FOR IDENTIFYING WAFERS IN CHIP MANUFACTURING AND DEVICE FOR ITS IMPLEMENTATION
PROCEDE D'IDENTIFICATION DE TRANCHES LORS DE LA FABRICATION DE PUCES ET DISPOSITIF POUR LA MISE EN OEUVRE DUDIT PROCEDE

(30) Priorität: 30.09.1996 DE 19640425
(43) Veröffentlichungstag der Anmeldung: 01.09.1999
(73) Patentinhaber: Infineon Technologies AG, 81669 München (DE)
(72) Erfinder: WOHLLEBEN, Jürgen, D-92521 Schwarzenfeld (DE); FREUNDORFER, Johannes, D-94560 Offenberg (DE)
(86) Internationale Anmeldenummer: DE9702234
(87) Internationale Veröffentlichungsnummer: WO9814984

(56) Entgegenhaltungen:
- US-A- 5 155 888
- PATENT ABSTRACTS OF JAPAN vol. 017, no. 648 (M-1518), 2.Dezember 1993 -& JP 05 208716 A (NEC CORP), 20.August 1993,

## Beschreibung

Die Erfindung betrifft ein Verfahren zur Waferidentifizierung, wobei Wafer (Halbleiterscheiben) meist im Lieferzustand bereits eine Strichcodemarke besitzen, anhand der sie identifiziert werden können. Diese Identifizierung erfolgt durch Strichcodeleseköpfe, die die Strichcodierung in der Regel optisch abtasten. Eine entsprechende Vorrichtung sorgt für die Handhabung der Wafer während des Lesevorganges.

Mit der Zielrichtung einer fortlaufenden Optimierung von Fertigungsprozessen werden regelmäßig Arbeitsschritte oder ganze Fertigungsabläufe automatisiert und verschiedenartig überwacht und bei komplexen Systemen wird die Fertigung von einem Anlagenrechner oder Prozeßleitrechner gesteuert und überwacht. Im Rahmen der Einführung einer Waferidentifizierung wurden Strichcodierungen auf den Wafern eingeführt. Hierbei wird vornehmlich der standardisierte Barcode BC412 verwendet. Dieser Barcode wird in einer Laserbeschriftungsanlage auf den Siliziumwafern durch Aneinanderreihung von kleinen Vertiefungen, sog. Dot's, aufgebracht. Zur Identifizierung werden sog. Scanner eingesetzt, die als Leseeinheit oder als Lesekopf bezeichnet werden. Die auf dem Wafer angebrachten Informationen geben beispielsweise Auskunft über Herkunft, Fertigungsstandort, Losnummer oder Lieferwoche.

Für die Prozeßüberwachung ist nicht nur die Kenntnis der innerhalb des Prozesses eingestellten Parameter notwendig, sondern die Daten der Ausgangsmaterialien, die dem Prozeß als nächstes zugeführt werden, sind ebenso wichtig. Dieser Informationsabgleich ist in einer CIM-Landschaft (Computer Integrated Manufacturing) notwendig. Somit kann andererseits kontrolliert werden, ob die Anlage, das Anlagenprogramm, der Prozeß oder Verfahren und das Los übereinstimmen. Durch diesen abschließenden Brückenschlag zwischen Informationsaufbereitung einerseits und Losidentifizierung andererseits können Fehl-, Doppel- und Falschprozessierungen vermieden werden. Somit werden prozeßrelevante Korrelationen für Auswertungen bezüglich der Ausbeute und der Optimierung erzielt. Prinzipiell können die von Detektionseinheiten erfaßten Daten automatisch oder mittels einer Tastatur an ein Rechenleitsystem weitergegeben werden.

Für die sog. Front-End-Fertigung, die die Prozeßierung eines Wafers bis hin zum Prüffeld, in dem die noch nicht vereinzelten Wafer geprüft werden, umfaßt, sollten somit idealer Weise sämtliche verfügbaren Daten für das Rechensystem zur Verfügung stehen und eventuell regelmäßig aktualisiert werden. Aus diesem Grund sind in bestehenden Anlagen die Leseköpfe zur Identifizieung der Wafer innerhalb der Prozeßlinie angeordnet worden. Dabei stellte es sich jedoch heraus, daß die Leseköpfe nur mit erheblichem Aufwand und mit Steuerungsanpassungen, sowie mit mechanischen Umbauten und teilweise auch mit Durchsatzverlusten in die Anlagen integriert werden konnten. Insbesondere ist eine Abstimmung mit Herstellern der sehr komplexen Bearbeitungsanlagen fast unmöglich. Weiterhin hat es sich auch als nachteilig erwiesen einen sog. Handlings-Automaten nur für die Waferidentifizierung mit einem Barcodelesegerät auszustatten, da dies mit einem vollständigen Handlingsschritt verbunden wäre, bei dem der Wafer eine Horde vollständig verläßt.

Das Dokument US-A-5 155 888 offenbart ein Verfahren zur Waferidentifizierung wobei die Wafer zum Lesen einer Markierung aus einer Horde angehoben werden. Außerdem wird eine Vorrichtung zur Durchführung des Verfahrens offenbart.

Der Erfindung liegt die Aufgabe zugrunde, ein Verfahren und eine Vorrichtung bereitzustellen, womit bei der Chipherstellung die Daten von Wafern zuverlässig und wirtschaftlich zu detektieren und einem Prozeßleitsystem zuzuführen.

Die Lösung dieser Aufgabe geschieht durch die Merkmale des Anspruchs 1 bzw. des Anspruchs 4.

Der Erfindung liegt die Erkenntnis zugrunde, daß die Aufnahme von auf Wafern aufgebrachten Informationen in der Chipherstellung sinnvollerweise vor dem Eintritt der Wafer in eine Bearbeitungsmaschine bzw. in die Prozessierung geschieht. Somit werden Informationen über den Wafer bzw. ein Los von Wafern an einen Anlagenrechner geliefert. Geschieht die Aufnahme dieser Daten unmittelbar bevor beispielsweise über einen Handlingsautomaten eine Horde mit Wafern der Prozessierung zugeführt wird, so lassen sich Verwechselungen weitestgehend ausschließen. Besondere Vorteile des erfindungsgemäßen Verfahrens bestehen darin, daß die Wafer zum Lesen der strichcodierten Markierungen aus der Horde lediglich angehoben werden. Dies genügt, um die Codierungen der Wafer unmittelbar vor ein Lesefenster eines Lesekopfes zu plazieren.

Die erfindungsgemäße Vorrichtung ist so ausgelegt, daß eine Horde mit beispielsweise einem Los von Wafern an einer Ladestation arretiert wird. Innerhalb der Horde sind die Wafer in sog. Slots (Schlitzen) untergebracht. Die Hebe- und Lesestation befindet sich dabei an einem vorgegebenen Platz, der mit einem Wafer besetzt ist und mittels der Hebe- und Lesestation angehoben und identifiziert werden kann. Aus den Erfahrungen der Fertigung kann die Hebe- und Lesestation beispielsweise an einer mittigen Position der Horde plaziert sein, wenn das Los der Wafer einheitlich ist.

Um Verwechselungen restlos auszuschließen, ist es besonders vorteilhaft, sämtliche Wafer in einer Horde zu identifizieren. Dies geschieht sukzessive, wobei jeweils ein Wafer durch die Hebe- und Lesestation aus der Horde angehoben wird, ein Lesekopf die Strichcodierung auf dem Wafer abtastet und der Wafer wieder in die Horde bzw. in den Schlitz abgelegt wird. Durch entsprechendes Verfahren der Hebe- und Lesestation mittels einer Linearachse können sämtliche Wafer in einer Horde bedient werden.

Weitere vorteilhafte Ausgestaltungen sind den Unteransprüchen zu entnehmen.

Im folgenden wird anhand von schematischen Figuren ein Ausführungsbeispiel beschrieben.
Figur 1 zeigt ein Fertigungsüberwachungssystem für die Chipfertigung,
Figur 2 zeigt einen Slotscanner,
Figur 3 zeigt einen Hordenscanner,
Figur 4 zeigt den prinzipiellen Aufbau eines Slotscanners entsprechend Figur 2,
Figur 5 zeigt mehrere Verfahrensschritte zur Waferidentifizierung,
Figur 6 zeigt einen Hordenscanner in Verbindung mit einer Einheit zum Ausrichten der Wafer in einer Horde.

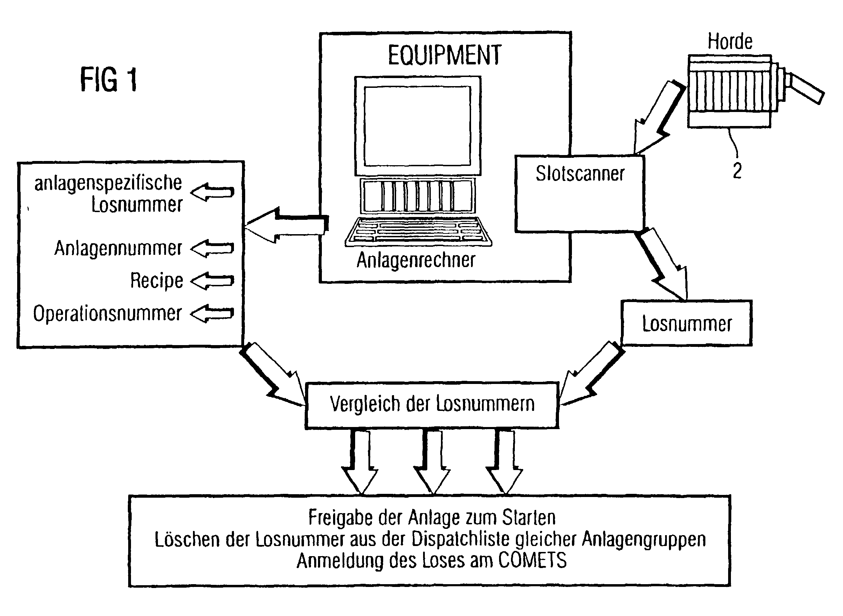

In der Figur 1 wird schematisch die über einen Anlagenrechner gesteuerte Datenverknüpfung bzw. Informationsaufbereitung dargestellt. Einerseits wird vom Anlagenrechner eine bestimmte Menge von Informationen (linke Bildhälfte von Figur 1) gespeichert bzw. bereitgestellt und andererseits wird über einen Slotscanner beispielsweise die Losnummer der Wafer in einer Horde detektiert und dem Rechner übermittelt. Das System vergleicht die anlagenspezifischen Daten mit den Daten der bereitgestellten Wafer und prüft, ob die Fertigungsanlage freigegeben werden kann. Im Anschluß daran wird die Losnummer der Wafer der aktuellen Horde aus dem Vorratsbereich gestrichen und diese aktuelles Los wird am System zur Prozessierung angemeldet.

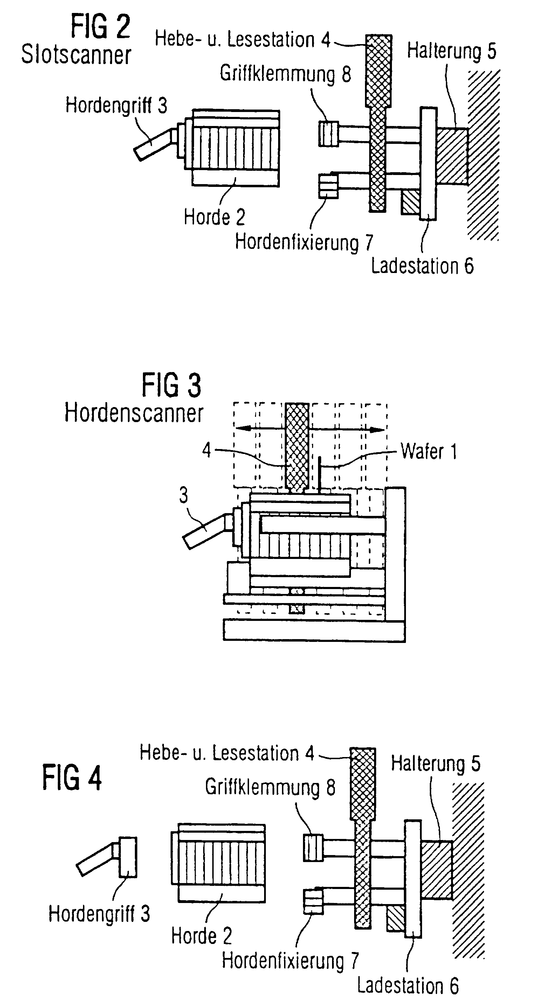

Die Figuren 2 und 3 können im Zusammenhang betrachtet werden. Figur 2 zeigt einen sog. Slotscanner (Scanner = Abtasteinheit bzw. Leseeinheit; Slot = Schlitz bzw. Box eines Wafers 1 in einer Horde 2). Figur 3 zeigt einen sog. Hordenscannner (Horde = Einheit, die einen Satz von Wafern aufnehmen kann). Der Slotscanner entsprechend Figur 2 kann mittels seiner Hebe- und Lesestation 4 an einer in einer Ladestation 6 arretierten Horde 2 lediglich eine einzige Identifizierung an einem Wafer an einer bestimmten Position innerhalb der Horde 2 vornehmen, da die Hebe- und Lesestation 4 nicht derart beweglich ist, daß verschiedene Wafer 1 bedient werden können. Der Hordenscanner entsprechend Figur 3 enthält eine Linearachse, d.h. eine Einrichtung zur Bewegung der Hebe- und Lesestation 4 entsprechend der in Figur 3 angedeuteten Pfeilrichtung. Somit können sämtliche Wafer 1, die sich in einer Horde 2 befinden, nacheinander über die Hebe- und Lesestation 4 identifiziert werden. Dazu wird jeweils ein Wafer 1 aus der Horde 2 herausgehoben, mittels eines Lesekopfes, der nicht separat dargestellt ist, identifiziert und wieder in die Horde 2 abgelegt.

Figur 4 stellt den prinzipiellen Aufbau eines Slotscanners entsprechend Figur 2 dar, wobei der abnehmbare Hordengriff 3 separat dargestellt ist. Die Ladestation 6 ist an einer Halterung 5 befestigt. Die Halterung 5 kann mittelbar oder unmittelbar an einer Fertigungsmaschine angebracht sein.

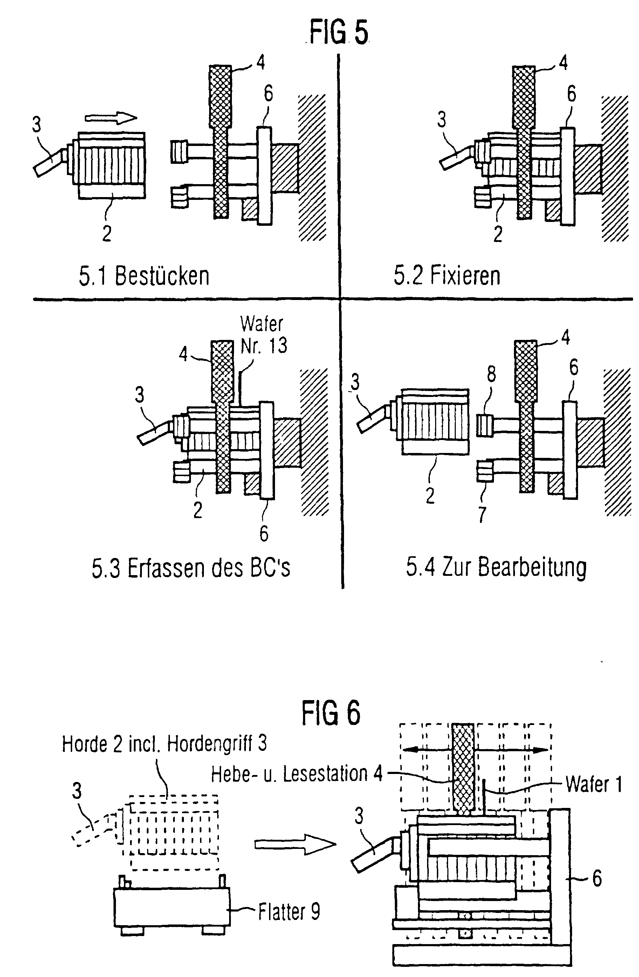

In der Figur 5 wird durch vier verschiedene Zustände der Ablauf zur Waferidentifizierung in einer Ladestation 6 mit einer Hebe- und Lesestation 4 detailliert dargestellt. Zunächst wird die Ladestation 6 mit der Horde 2 bestückt. Anschließend daran wird die Horde 2 in der Ladestation 6 durch die Hordenfixierung 7 und die Griffklemmung 8 fixiert. Nun kann ein Wafer 1 beispielsweise der Wafer mit der Nummer 13 durch die Hebe- und Lesestation 4 angehoben, gelesen und wieder abgesenkt werden. Bei einem einheitlichen Los, das mehrere gleiche Wafer 1 beinhaltet, reicht diese Identifzierung aus. Nachdem jedoch während der Prozessierung der Wafer 1 ein mehrfaches Ein- und Ausladen der Wafer 1 zur entsprechenden Bearbeitung geschieht, ist es durchaus möglich, daß die Reihenfolge vertauscht wird und sich irgendwelche Überschneidungen ergeben. Um sicherzugehen, daß jeder Wafer 1 während des gesamten Bearbeitungsprozesses zuverlässig überwacht werden kann, ist eine umfassende anfängliche Identifizierung notwendig. Dazu wird ein sog. Hordenscanner eingesetzt, der sukzessive jeden Wafer 1 einer Horde 2 in der Hebe- und Lesestation 4 identifziert. Dies wird in den Figuren 3 und 6 dargestellt. Die Figur 6 zeigt zusätzlich einen sog. Flatter 9 (Einheit zum einheitlichen Ausrichten der Wafer 1 in einer Horde 2), der sämtliche Wafer 1 zu Beginn des Verfahrens entsprechend einer Marke (Flat) am Wafer ausrichtet. Dieses Flat wird in der Regel durch ein kleines Segment am Wafer dargestellt, wobei ein Segment vom Wafer 1 entfernt wurde. Da sich die Beschriftung an diesem Flat der Scheibe befindet,müssen der Barcode bzw. die Wafer 1 vor der Identifizierung für den Lesevorgang durch einheitliche Ausrichtung innerhalb der Horde 2 entsprechend positioniert werden. Somit können in der Hebe- und Lesestation 4 die Strichcodierungen problemlos detektiert werden. Nachdem jedoch die einheitliche Ausrichtung der Wafer in einem Los bereits bisher durchgeführt wurde, stellt dies keinen Mehraufwand dar. Ist es aus prozeßtechnischer Sicht sinnvoll, alle Wafer eines Loses für eine spätere Prozeßzuordnung zu identifizieren, so kann beispielsweise auch eine sequentielle Wafererfassung angewandt werden. Handelsübliche Horden verfügen beispielsweise über 25 Slots in denen die Waferscheiben stehen. Der Slotscanner identifiziert beispielsweise den 13. Wafer einer Horde. Dies basiert darauf, daß die Wahrscheinlichkeit im 13. Slot einen Wafer 1 vorzufinden relativ hoch ist. Sollte die Losgröße beispielsweise 50 Wafer, also zwei Horden betragen, kann durch den Vergleich der jeweils 13. Slots der beiden Horden des Loses eine Verwechselung der Horden weitgehend ausgeschlossen werden. Dies gilt insbesondere dann, wenn die Anlage die Wafer sequentiell bearbeitet, so daß sich irgendein Wafer vor der Bearbeitung, beispielsweise im Slot 1 befand und sich nach der Bearbeitung beispielsweise im Slot 25 befindet. Der Wafer im Slot 13 bleibt aber auch beim Vertauschen der Slotpositionen immer der Gleiche.

Anhand des Aüsführungsbeispiels können insbesondere folgende Vorteile erzielt werden:
- die Horde 2 ist während des Lesevorganges gesichert, wodurch Brüche an den Wafern 1 vermieden werden,
- mittels eines Slotscanners ist eine Einzelscheibenerfassung möglich,
- mittels eines mit einer Linearachse ausgerüsteten Hordenscanners ist ein sequentielles Erfassen der Wafer 1 möglich,
- die Erfassungseinheit, die die Informationen der Wafer detektiert und umsetzt, stellt eine selbstständige Einheit dar, die einer Bearbeitungslinie vorgeschaltet ist. Nachdem die detektierten Daten dem Prozeßleitsystem zugeführt werden, erübrigt sich die sehr aufwendige Detektion von Informationen auf Wafern innerhalb der Fertigungslinie an einzelnen Stationen,
- eine kostenoptimierte modulare und reinraumgerechte Bauweise ist möglich,
- ein vollständiger Handlingvorgang, der die Wafer 1 vollständig aus einem Slot entnimmt, entfällt.

## Patentansprüche

1. Verfahren zur Waferidentifizierung in der Chipfertigung unter Einsatz einer Strichcodeleseeinheit, die eine Strichcodierung auf Wafern (1) liest und die Information an eine Rechnereinheit zur Steuerung des Bearbeitungsprozesses für die Wafer (1) liefert, wobei die Wafer (1):
- sich bei der Identifizierung vor dem Bearbeitungsprozeß in einer Horde (2) befinden, die in eine Ladestation (6) vor oder an einer Bearbeitungsmaschine eingelegt ist,
- mittels einer Hebe- und Lesestation (4) zum Lesen der strichcodierten Daten einzeln angehoben werden,
- wieder in die Horde (2) abgelegt werden und
- der Bearbeitungsstation einzeln zugeführt werden.

2. Verfahren nach Anspruch 1, worin in der Hebe- und Lesestation (4) sämtliche Wafer (1) hintereinander zur Strichcodeidentifizierung erfaßt werden.

3. Verfahren nach einem der vorhergehenden Ansprüche, worin sämtliche Wafer (1) einer Horde (2) vor der Strichcodeidentifzierung in Verbindung mit einer auf den Wafern (1) befindlichen Marke ausgerichtet werden.

4. Vorrichtung zur Durchführung des Verfahrens nach einem der Ansprüche 1 bis 3, worin diese den Bearbeitungsprozeß vorgeschaltete Vorrichtung zur Strichcodeidentifizierung für Wafer (1) folgende Bestandteile aufweist:
- eine Ladestation (6) zur Aufnahme einer Horde (2), die eine Vielzahl von Wafern (1) beinhaltet,
- eine Hordenfixierung (7) zur Fixierung der Horde (2) innerhalb der Ladestation (6),
- eine Hebe- und Lesestation (4) mit einem Barcodelesekopf, zur Anhebung eines einzelnen Wafers (1) an einer bestimmten Position innerhalb der Horde (2) um die auf dem Wafer befindlichen Daten zu lesen,
- einer Einheit zur Übertragung der gelesenen Daten an eine Rechnereinheit zur Steuerung des für die in der Horde (2) befindlichen Wafer (1) vorgesehenen Bearbeitungs prozesses.

5. Vorrichtung nach Anspruch 4, worin zur Handhabung der Horde (2) ein Hordengriff (3) vorgesehen ist, der in der Ladestation (6) zusätzlich in einer Griffklemmung (8) arretierbar ist.

6. Vorrichtung nach einem der Ansprüche 4 oder 5, worin die Hebe- und Lesestation (4) zusätzlich mit einer Linearachse ausgestattet ist, so daß sie relativ zu jedem Wafer (1) innerhalb einer Horde (2) positionierbar ist.

7. Vorrichtung nach einem der Ansprüche 4 bis 6, worin an die Ladestation (6) eine Einheit zum gleichmäßigem Ausrichten der Wafer (2) angeschlossen ist.

## Claims

1. Method for identifying wafers in chip manufacturing using a bar code reading unit which reads a bar code on wafers (1) and supplies the information to a computer unit for controlling the processing process for the wafers (1), the wafers (1):
- being situated in a rack (2) during identification before the processing process, which rack is inserted into a loading station (6) upstream of or on a processing machine,
- being raised individually by means of a lifting and reading station (4) for reading the bar-coded data,
- being deposited back into the rack (2) and
- being fed individually to the processing station.

2. Method according to Claim 1, wherein, in the lifting and reading station (4), all the wafers (1) are acquired successively for the purpose of bar code identification.

3. Method according to one of the preceding claims, wherein all the wafers (1) of a rack (2), before the bar code identification, are oriented in connection with a marker situated on the wafers (1).

4. Apparatus for carrying out the method according to one of Claims 1 to 3, wherein this apparatus-connected upstream of the processing process - for bar code identification for wafers (1) has the following component parts:
- a loading station (6) for receiving a rack (2) comprising a multiplicity of wafers (1),
- a rack fixing (7) for fixing the rack (2) within the loading station (6),
- a lifting and reading station (4) with a bar code reading head, for raising an individual wafer (1) at a specific position within the rack (2) in order to read the data held on the wafer,
- a unit for transmitting the data read to a computer unit for controlling the processing process provided for the wafers (1) situated in the rack (2).

5. Apparatus according to Claim 4, wherein a rack handle (3) is provided for handling the rack (2), which rack handle can additionally be locked in a handle clamp (8) in the loading station (6).

6. Apparatus according to either of Claims 4 and 5, wherein the lifting and reading station (4) is additionally equipped with a linear axis, so that it can be positioned relative to each wafer (1) within a rack (2).

7. Apparatus according to one of Claims 4 to 6, wherein a unit for uniformly orienting the wafers (2) is connected to the loading station (6).

## Revendications

1. Procédé pour l'identification de tranches dans la fabrication de puces en utilisant une unité de lecture de codes à barres qui lit un code à barres sur des tranches (1) et qui fournit les informations à un ordinateur pour la commande du processus de traitement pour les tranches (1), dans lequel les tranches (1) :
- se trouvent lors de l'identification, avant le processus de traitement, dans un panier (2) qui est placé dans un poste de chargement (6) avant ou au niveau d'une machine de traitement,
- sont soulevées individuellement au moyen d'un poste de soulèvement et de lecture (4) pour la lecture des données en codes à barres,
- sont reposées dans le panier (2), et
- sont envoyées individuellement au poste de traitement.

2. Procédé selon la revendication 1, dans lequel, dans le poste de soulèvement et de lecture (4), toutes les tranches (1) sont saisies les unes après les autres pour l'identification de codes à barres.

3. Procédé selon l'une des revendications précédentes, dans lequel, avant l'identification de codes à barres, toutes les tranches (1) d'un panier (2) sont orientées selon une marque se trouvant sur les tranches (1).

4. Dispositif pour la mise en oeuvre du procédé selon l'une des revendications 1 à 3, dans lequel ce dispositif placé du côté amont du processus de traitement pour l'identification de codes à barres pour des tranches (1) comporte les éléments suivants :
- un poste de chargement (6) pour recevoir un panier (2) qui contient une multiplicité de tranches (1),
- une fixation de panier (7) pour fixer le panier (2) à l'intérieur du poste de chargement (6),
- un poste de soulèvement et de lecture (4) ayant une tête de lecture de codes à barres pour soulever une tranche individuelle (1) dans une certaine position à l'intérieur du panier (2) afin de lire les données se trouvant sur la tranche,
- une unité pour transmettre les données lues à un ordinateur pour la commande du processus de traitement prévu pour les tranches (1) se trouvant dans le panier (2).

5. Dispositif selon la revendication 4, dans lequel il est prévu pour la manipulation du panier (2) une poignée de panier (3) qui, dans le poste de chargement (6), peut être bloquée en plus dans un serrage de prise (8).

6. Dispositif selon l'une des revendications 4 ou 5, dans lequel le poste de soulèvement et de lecture (4) est équipé en plus d'un axe linéaire de telle sorte qu'il peut être positionné par rapport à chaque tranche (1) à l'intérieur d'un panier (2).

7. Dispositif selon l'une des revendications 4 à 6, dans lequel une unité pour l'orientation uniforme des tranches (2) est raccordée au poste de chargement (6).
